# EUROPÄISCHE PATENTANMELDUNG

(11) **EP 1 022 851 A2**
(43) Veröffentlichungstag der Anmeldung: **26.07.2000**
(21) Anmeldenummer: 00200181.6
(22) Anmeldetag: 17.01.2000
(51) Int. Cl.: H03H 7/06

(54) **Zero-IF-Konverter mit RC-Filter**

(30) Priorität: 25.01.1999 DE 19902865
(71) Anmelder: Philips Corporate Intellectual Property GmbH, 52064 Aachen (DE); Koninklijke Philips Electronics N.V., 5621 BA Eindhoven (NL)
(72) Erfinder: Löbl, Hans Peter, 52064 Aachen (DE); van Oppen, Paul Henri Maria, 52064 Aachen (DE); Rijks, Theo, 52064 Aachen (DE); Klee, Mareike, 52064 Aachen (DE); Doodeman, Gert, 52064 Aachen (DE)
(74) Vertreter: Volmer, Georg, Dipl.-Ing.

(57) **Zusammenfassung**

Ein Zero-IF-Konverter, insbesondere für digitale Satellitenempfänger, mit einem Dünnschichtbauteil mit mindestens zwei RC-Filtern mit jeweils einem Widerstand und einem Kondensator mit jeweils einer Unterelektrode, einer Oberelektrode und einem Dielektrikum, bei dem die RC-Filter auf einem gemeinsamen Substrat angeordnet sind, zeichnet sich durch eine konstante Amplituden- und Phasenrelation zwischen den Basis-Signalen I und Q aus.

## Beschreibung

Die Erfindung betrifft einen Zero-IF-Konverter mit einem Dünnschichtbauteil mit mindestens zwei RC-Filtern mit jeweils einem Widerstand und einem Kondensator mit einer Unterelektrode, einem Dielektrikum und einer Oberelektrode.

Filter in Zero-IF-Konvertern für digitale Satellitenempfängern werden heutzutage symmetrisch aus einzelnen Kondensatoren und Spulen für die beiden Signale des Basisbandes I und Q aufgebaut. Ein Nachteil dieser Anordnung ist es, daß bei Verwendung kostengünstiger Komponenten, die Genauigkeit der Spulen und Kondensatoren gering ist. Dadurch wird die Phasenbeziehung zwischen den Signalen des Basisbandes I und Q schwer reproduzierbar. Es müssen daher teuere Spulen und Kondensatoren mit engen Toleranzen eingesetzt werden. Weiterhin führt die Temperaturabhängigkeit der Bauelemente zu einer Veränderung der Phasenbeziehung zwischen I und Q, wenn die Temperaturdrift der Komponenten in beiden Signalzweigen verschieden ist. Zusätzlich führt die Realisierung eines Filters auf konventionelle Weise mit diskreten Spulen und Kondensatoren oder Widerständen und Kondensatoren zu sehr großen Abmessungen.

In US 5,629,655 wird ein skalierbarer Sperr-Notch-Filter vorgeschlagen, der wenigstens einen Eingang und wenigstens einen Ausgang und eine Erdung, eine erste Anzahl von Widerstandselementen, als Dünnschicht abgeschieden auf einer entsprechenden Anzahl von leitfähigen Platten mit dielektrischen Zwischenschichten, wobei die Widerstandselemente zwischen dem Eingang und dem Ausgang in Serie geschaltet sind, und ein zweite Anzahl von Schaltern, die selektiv so angeordnet sind, um bestimmte leitfähige Platten zu einem Widerstand zusammenzuschalten, der mit der Erde verbunden ist, und Mittel, um den Wert des Widerstands zu verändern, je nachdem welche leitfähigen Planen zu dem Widerstand zusammengeschaltet sind. Mit dieser Anordnung sollen die Probleme einer Massenfertigung unter Kontrolle gebracht werden.

Es ist die Aufgabe der vorliegenden Erfindung, einen Zero-IF-Konverter hoher Güte zur Verfügung zu stellen, bei dem die Phasen- und Amplitudenbeziehung zwischen zwei oder mehreren Signalen extrem stabil ist.

Erfindungsgemäß wird die Aufgabe durch einen Zero-IF-Konverter mit einem Dünnschichtbauteil mit mindestens zwei RC-Filtern mit jeweils einem Widerstand und einem Kondensator mir einer Unterelektrode, einer Oberelektrode und einem Dielektrikum, wobei die RC-Filter auf einem gemeinsamen Substrat angeordnet sind, gelöst. Ein derartiger Zero-IF-Konverter zeichnet sich durch enge Toleranzen, kleine Abmessungen und eine konstante Amplituden- und Phasenrelation zwischen den Basis-Signalen I und Q aus.

Im Rahmen der vorliegender Erfindung ist es bevorzugt, daß mindestens ein RC-Filter ein verteilter RC-Filter ist.

Mindestens ein RC-Filter kann auch ein diskreter RC-Filter sein.

Die Oberelektrode des verteilten RC-Filters kann widerstandsbehaftet sein.

Es ist bevorzugt, daß die Unterelektrode des verteilten RC-Filters widerstandsbehaftet ist.

Es kann auch bevorzugt sein, daß mindestens ein RC-Filter ein RC-Notch-Filter mit einem Notch-Widerstand ist.

Im Rahmen der vorliegenden Erfindung ist es besonders bevorzugt, daß mindestens ein RC-Filter ein verteilter RC-Filter und der Notch-Widerstand ein verteiltes Widerstandsbauelement ist- Diese Ausführungsform hat eine einfache Bauweise, eine sehr gute Frequenzcharakteristik und sehr gute Stabilität gegenüber Prozeßvariationen.

Weiterhin kann es bevorzugt sein, daß das Substrat aus einem wärmeleitfähigen Material besteht. Durch die Realisierung der RC-Filter auf einem wärmeleitfähigen Material wie Al₂O₃ wird sichergestellt, daß der Temperaturgang der RC-Filter identisch ist.

Die Erfindung betrifft auch ein Dünnschichtbauteil mit mindestens zwei RC-Filtern mit jeweils einem Widerstand und einem Kondensator mit jeweils einer Unterelektrode, einer Oberelektrode und einem Dielektrikum, wobei die RC-Filter auf einem gemeinsamen Substrat angeordnet sind.

Nachfolgend wird die Erfindung anhand von drei Ausführungsbeispielen und neun Figuren weiter erläutert.
Fig. 1 zeigt die Prinzipschaltung eines Dünnschichtbauteils nach der Erfindung mit zwei RC-Notch-Filtern mit diskretem Notch-Widerstand.
Fig. 2 zeigt einen Querschnitt durch ein Dünnschichtbauteil gemäß Fig. 1.
Fig. 3 zeigt die Aufsicht auf ein Dünnschichtbauteil gemäß Fig. 1.
Fig. 4 zeigt die Prinzipschaltung eines Dünnschichtbauteils nach der Erfindung mit zwei RC-Notch-Filtern mit verteiltem Notch-Widersrand.
Fig. 5 zeigt einen Querschnitt durch ein Dünnschichtbauteil gemäß Fig. 4.
Fig. 6 zeigt die Aufsicht auf ein Dünnschichtbauteil gemäß Fig. 4.
Fig. 7 zeigt das Übertragungsverhalten eines Dünnschichtbauteils gemäß Fig. 4.
Fig. 8 zeigt die Prinzipschaltung eines Dünnschichtbauteils mit zwei diskreten RC-Filtern.
Fig. 9 zeigt das Übertragungsverhalten eines Dünnschichtbauteils gemäß Fig. 8.

Ein Zero-IF-Konverter nach der Erfindung enthält ein Dünnschichtbauteil mir mindestens zwei RC-Filtern mir jeweils einem Widerstand und einem Kondensator mir jeweils einer Oberelektrode 1, einem Dielektrikum 2 und einer Unterelektrode 3, die auf einem gemeinsamen Substrat angeordnet sind.

Die Widerstände und die Kondensatoren, aus denen sich die RC-Filter zusammensetzen, und der Notchwiderstand können in einer diskreten oder in einer verteilten Bauweise ausgeführt sein.

Beispielsweise kann das Dünnschichtbauteil eine Bauweise haben, bei der die RC-Notch-Filter mit verteilter widerstandsbehafteter Ober- und verteilter widerstandsbehafteter Unterelektrode aufgebaut sind.

Das Dünnschichtbauteil kann auch eine Bauweise haben, bei der die RC-Notch-Filter mit verteilter widerstandsbehafteter Ober- und gut leitender Unter- Elektrode aufgebaut sind. Der Notch-Widersrand zwischen Unterelektrode und Masse ist dann als diskreter, auf dem Substrat integrierter Dünnschichtwiderstand, ausgeführt.

In einer weiteren Ausführungsform kann das Dünnschichtbauteil eine Bauweise haben, bei der die RC-Notch-Filter mit verteilter widerstandsbehafteter Unter- und gut leitender Oberelektrode aufgebaut sind. Der Notch-Widerstand von der oberen Elektrode nach Masse ist dann als diskreter, auf dem Substrat integrierter Dünnschichtwiderstand, ausgeführt.

Das Dünnschichtbauteil kann auch eine Bauweise haben, bei der die RC-Norch-Filter aus diskreten auf einem Substrat integrierten Dünnschichtwiderständen und Dünnfilmkondensatoren ausgeführt sind.

Im allgemeinen ist je ein Filter für die beiden Signale des Basisbandes, I und Q vorgesehen und die beiden Filter werden symmetrisch auf dem gemeinsamen Substrat realisiert. Die verteilten RC- Filter haben das Übertragungsverhalten eines Tiefpasses. Verteilte RC-Notch-Filter haben das Übertragungsverhalten eines Tiefpasses mit zusätzlich einer starken Dämpfung bei einer bestimmten Frequenz (,Notch').

Das Dünnschichtbauteil kann mittels bekannter Dünnschichttechniken und Photolithographieverfahren hergestellt werden. Durch den Einsatz von Dünnschichttechnologien zur Realisierung dieser verteilten RC-Filter werden sehr enge Toleranzen des Filters erreicht. Durch die Realisierung beider Filter auf einem gut wärmeleitenden Substrat wie z.B. Al₂O₃ wird zusätzlich sichergestellt, daß der Temperaturgang beider Filter identisch ist und die Phasen- und Amplitudenbeziehung zwischen I und Q erhalten bleibt. Durch den Einsatz der Dünnschichttechnik und der Realisierung von Kondensatoren und Widerständen auf einem Substrat wird in dem erfindungsgemäßen Verfahren eine sehr kleines RC-Filter realisiert, verglichen mit einem in konventioneller Bauweise aufgebauten Filter.

Als Werkstoff für das gemeinsame Substrat werdenSubstrate eingesetzt, die bevorzugt aus einem wärmeleitfähigen Material, wie. Aluminiumoxid mit und ohne Planarisierungsschichten (z.B. Glas), Glas oder Silicium, bestehen können.

Auf dem gemeinsamen Substrat können auch aktive Bauelemente wie z.B. Dioden oder andere aktive Schaltungen angeordnet sein. Die Dioden werden zum Beispiel zum ESD-Schutz des RC-Filters eingesetzt.

Je nach Ausführungsform der Erfindung können die Ober- und die Unterelektrode aus einem gut leitfähigen Material oder aus einem Widerstandsmaterial bestehen. Bevorzugt werden als Widerstandsmaterial Materialien, die eine geringe Temperaturabhängigkeit des spezifischen Widerstandes aufweisen. Als Widerstandsmaterialien mit besonders geringer Temperaturabhängigkeit können NiₓCr_{y} (0<x<1, 0<y<1), NiₓCr_{y}Al_{z} (0<x<1, 0<y<1, 0<z<1), CuₓNi_{y} (0<x<1, 0<y<1), TaₓN_{y}(0<x<1, 0<y<1), TiₓW_{y}(0<x<1, 0<y<1), TiₓW_{y}N_{z}(0<x<1, 0<y<1, 0<z<1), CrₓSi_{y}Oₓ(0<x<1, 0<y<1, 0<z<1), CrₓSi_{y}N_{z}(0<x<1, 0<y<1, 0<z<1) eingesetzt werden.

Alternativ können auch Widerstandsmaterialien mit größerer Temperaturabhängigkeit des spezifischen Widerstandes eingesetzt werden, die sich wie z. B. Poly-Silizium durch Kompatibilität mit IC-Prozessen auszeichnen. Die Temperaturabhängigkeit des Widerstandsmaterials kann für diese Ausführungsformen durch eine gegenläufige Temperaturabhängigkeit des entspechend gewählten Kondensatormaterials ausgeglichen werden.

Als Kondensatormaterial können SiₓN_{y}(0<x<1, 0<y<1), SiₓO_{y} (0<x<1, 0<y<1), SiₓO_{y}N_{z}H_{w} (0<x<1, 0<y<1, 0<z<, 0<w<1), AlₓO_{y}(0<x<1, 0<y<1), TiₓO_{y}(0<x<1, 0<y<1), TaₓO_{y} (0<x<1, 0<y<1), Ba₁₋ₓSrₓTiO₃ mit 0<x<1, SrZrₓTi₁₋ₓO₃ mit 0<x<1 mit oder ohne Mn-Dotierung, BaO-Ln₂O₃-TiO₂ mit Ln=La, Ce, Nd, Sm, Eu, MgO-TiO₂-CaO-Al₂O₃-SiO₂ mit Dotierung von Nb, Y, La, Pr, Ni; Ba₂Ti₉O₂₀, Ba₂Ti₉₋ₓZrₓO₂₀ mit 0<x<1, dotiert mit Mn; BaTi₅O₁₁ , BaTi₄O₉, Nb₂O₅, Mischoxide aus (Ta₂O₅)ₓ mit (Al₂O₃)₁₋ₓ oder (Ta₂O₅)ₓ mit (TiO₂)₁₋ₓ oder (Ta₂O₅)ₓ mit (Nb2O5)₁₋ₓ oder (Ta₂O₅)ₓ mit (SiO₂)₁₋ₓ; (Sr, Ca)(Ti, Zr)O₃; BaO-SrO-CaO-Nd₂O₃-Gd₂O₃-Nb₂O₅-TiO₂; CaSm₂Ti₅O₁₄; Zr(Ti, Sn)O₄; BaO-PbO-Nd₂O₃-Pr₂O₃-Bi₂O₃-TiO₂; Ba(Zr, Zn,Ta)O₃; Mischoxid von CaTiO₃ mir LaAlO₃; (Bi₃(Ni₂Nb)O₉)₁₋ₓ((Bi₂(ZnNb_{2(1+d)})_{y}O_{3+6y+5yd})ₓ mit 0<x<1, 0.5 < y < 1.5 und- 0.05 < d < +0.05; PbZrₓTi₁₋ₓO₃ mit 0<x<1 und mit und ohne Bleiüberschuß; Pb_{1-αy}La_{y}ZrₓTi₁₋ₓO₃ mit 0 < y < 0.20, 1.3 < α < 1.5; 0 < x < 1, Pb_{1-αy}La_{y}TiO₃ mit 0 < y < 0.3, 1.3 < α < 1.5; (Pb,Ca)TiO₃, BaTiO₃ dotiert mit Nb und Co, BaZrₓTi₁₋ₓO₃ mit 0<x<1, Ba_{1-y}Sr_{y}ZrₓTi₁₋ₓO₃ mit 0<x<1, 0 < y < 1, Ba₁₋ₓSrₓTiO₃ mit 0<x<1, SrTiO₃ mit Dotierungen von La, Nb, Fe, Mn, (BaTiO₃)ₓ+ (Nd₂O₃)_{y} +(TiO₂)_{z} mit 0.1 < x < 0.3, 0.2 < y < 0.4, 0.2 < z < 0.4 , CaZrO₃, (Sr,Ca)(Ti,Zr)O₃, (Sr,Ca,M)(Ti,Zr)O₃ mit M= Mg oder Zn; BaO-TiO₂-Nd₂O₃-Nb₂O₅, BaO-PbO-Nd₂O₃-TiO₂; Ba(Zn,Ta)O₃, BaZrO₃, PbNbₓ((Zr_{0.6}Sn_{0.4})_{1-y}Ti_{y}))₁₋ₓO₃, Pb(Mg_{1/3}Nb_{2/3})O₃]ₓ-[PbTiO₃]₁₋ₓ 0<x<1, (Pb,Ba,Sr)(Mg_{1/3}Nb_{2/3})ₓTi_{y}(Zn_{1/3}Nb_{2/3})_{1-x-y}O₃ mit 0<x<1, 0 < y <1, bleihaltige Perowskite wie Pb(Mg_{0.5}W_{0.5})O₃, Pb(Fe_{1/2}Nb_{1/2})O₃, Pb(Fe_{2/3}W_{1/3})O₃, Pb(Mg_{1/2}W_{1/2})O₃, Pb(Ni_{1/3}Nb_{2/3})O₃, Pb(Zn_{1/3}Nb_{2/3})O₃, Pb(Sc_{1/2}Ta_{1/2})O₃, sowie Kombinationen dieser bleihaltigen Perowskite mit PbTiO₃ und Pb(Mg_{1/3}Nb_{2/3})O₃ mit oder ohne Bleiüberschuß verwendet werden.

### Ausführungsbeispiel 1

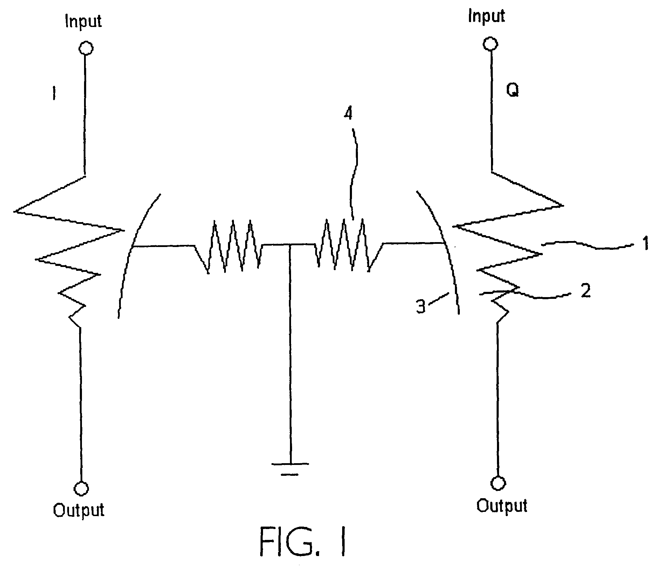

Diese Ausführungsform betrifft ein Dünnschichtbauteil mit zwei verteilten RC-Notch-Filtern mit diskretem Notch-Widerstand auf einem Al₂O₃ Substrat der Größe 1210 (3.0 mm x 2.4 mm) gemäß der Prinzipschaltung Fig. 1. Dabei bildet die verteilte Oberelektrode den Eingang bzw. den Ausgang des Filters. Die Unterelektrode ist über einen Notch-Widerstand R mit Erde verbunden.

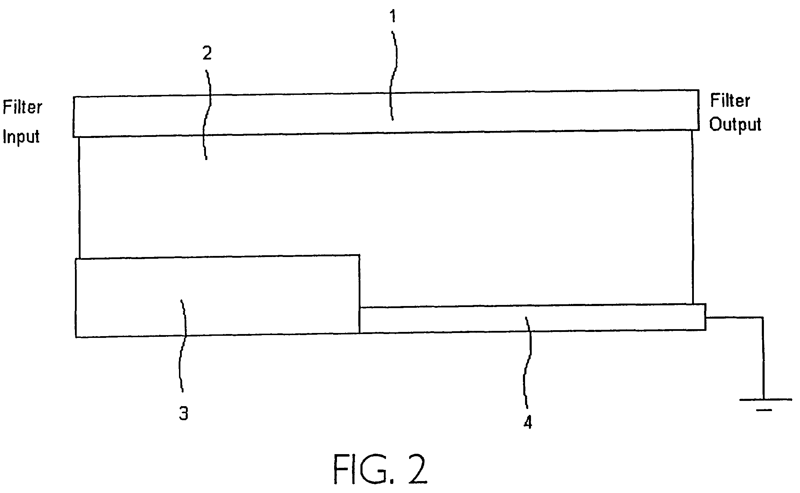

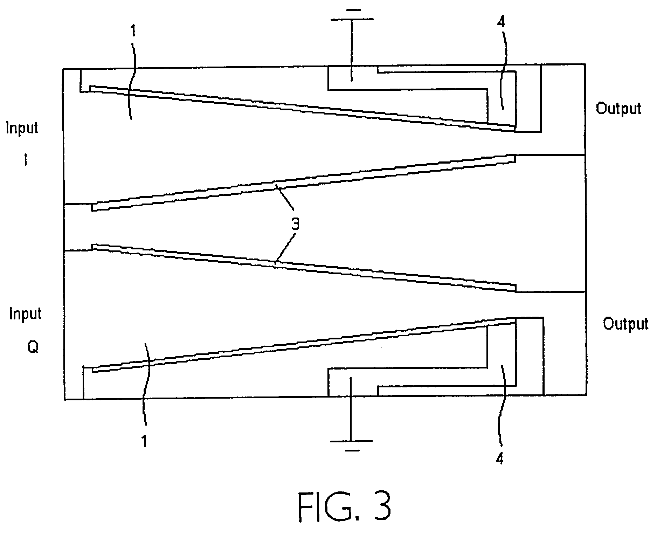

Der Aufbau des Dünnschichtbauteils ist in Fig. 2 und 3 gezeigt. Auf einer strukturierten Unterelektrode aus Al mit ca. 0.5 - 3 µm Dicke wird eine dielektrische Schicht mit einer Dicke von 1,1 µm und 55 pF/mm² abgeschieden. Darauf wird eine Oberelektrode als verteilte Widersrandsschicht aus NiCrAl mir einem Flächenwiderstand von ca. 100Ω/□ angebracht. Mit der Unterelektrode verbunden ist ein diskreter Notch-Widersrand aus NiCrAl mit 15.8 Ω. Dieser Widerstand wird bei Betrieb des Filters elektrisch mit Erde verbunden. Eingang und Ausgang des Filters sind an der Oberelektrode.

In einer anderen Ausführungsform sind die Unterelektrode und die Oberelektrode vertauscht. Der diskrete Widerstand ist dann mit der Oberelektrode verbunden und von dort nach Erde verbunden.

Das Dünnschichtbauteil ist mit einer Schutzschicht aus Si₃N₄ oder Polyimid gegen den Eintritt von Feuchtigkeit geschützt und mir Standard SMD-Endkontakten aus Cu/Ni/Sn versehen.

### Ausführungsbeispiel 2

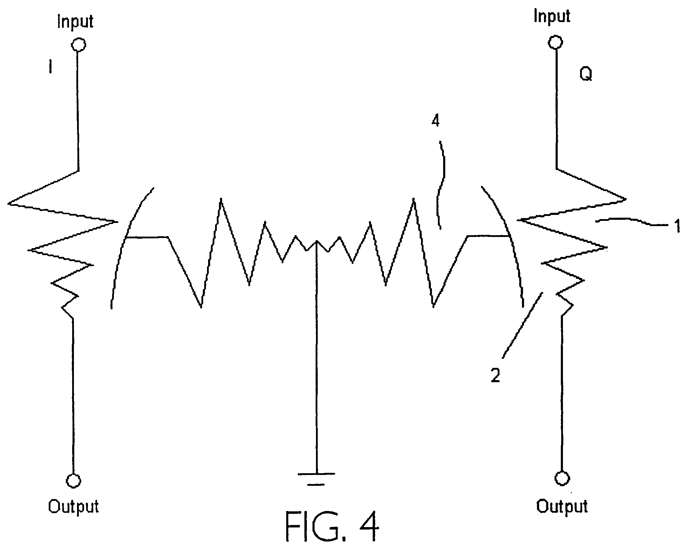

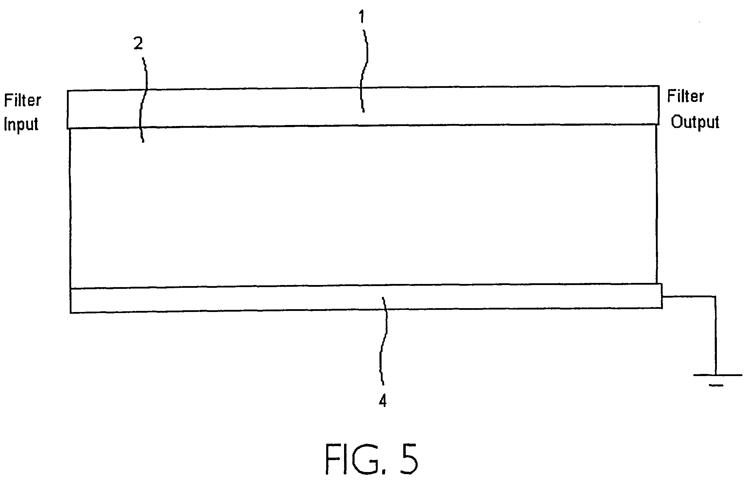

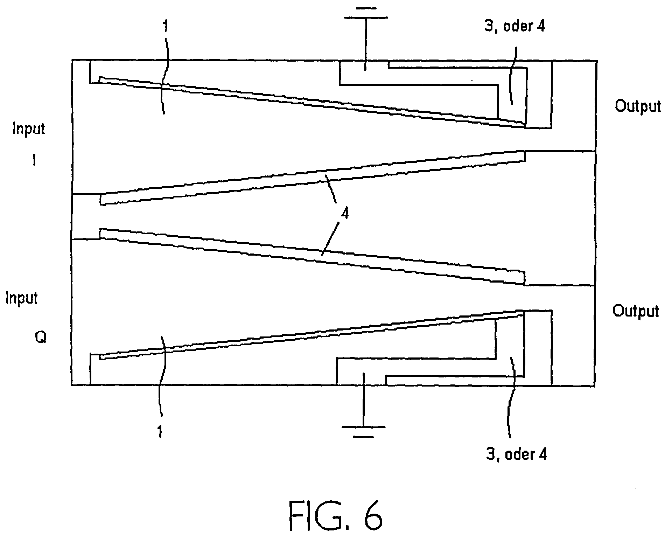

Diese Ausführungsform betrifft ein Dünnschichtbauteil mit zwei verteilten RC-Notch-Filtern mit verteiltem Notch-Widerstand auf einem Al₂O₃ Substrat der Größe 1210 (3.0 mm x 2.4 mm) gemäß dem Prinzipschaltbild Fig. 4. Der Aufbau des Dünnschichtbauteils ist in Fig. 5 und 6 gezeigt. Auf einer Unterelektrode aus einer NiCrAl-Widerstandsschicht mit einem Flächenwiderstand von 8.5 Ω/□ wird eine dielektrische Schicht aus 1,1µm dickem Si₃N₄ als Kondensator mit 55 pF/mm² abgeschieden. Darauf wird dann eine Widerstandsschicht aus NiCrAl als Oberelektrode mit einem Flächenwiderstand von 100Ω/□ angebracht. Die Unterelektrode stellt selbst einen verteilten Notch-Widerstand dar und ist beim Betrieb des Filters elektrisch mit Erde verbunden.

Nach einer anderen Ausführungsform können die Unterelektrode und die Oberelektrode vertauscht sein. Die Oberelektrode stellt dann den verteilten Notch- Widerstand dar und wird beim Betrieb des Filters elektrisch mit Erde verbunden.

Das Dünnschichtbauteil wird mit einer Schutzschicht aus Si₃N₄ oder Polyimid gegen den Eintritt von Feuchtigkeit geschützt und mit Standard SMD-Endkontakten aus Cu/Ni/Sn versehen.

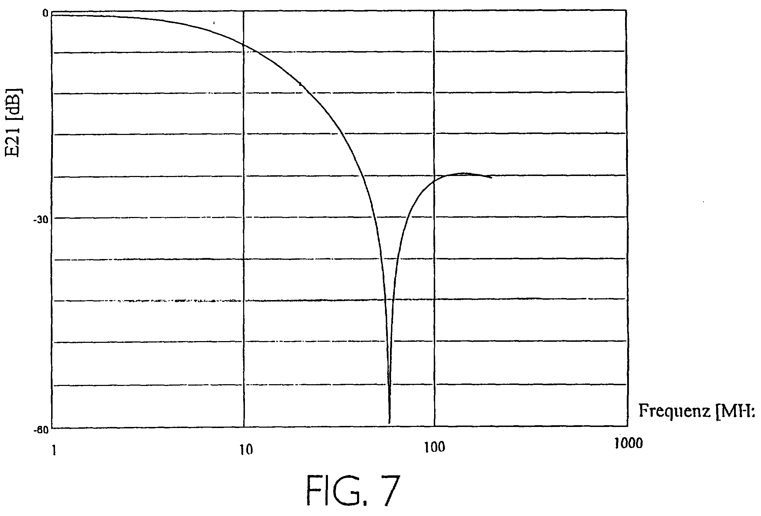

Das prinzipielle Übertragungsverhalten von Eingangsspannung zu Ausgangsspannung (Ua/Ue) eines solchen Dünnschichtbauteils mit zwei RC-Filtern ist in Fig. 7 in Abhängigkeit von der Frequenz dargestellt. Der Eingang wurde mit 50 Ω, der Ausgang mit 10 kΩ abgeschlossen.

### Ausführungsbeispiel 3

Diese Ausführungsform betrifft ein Dünnschichtbauteil mit zwei RC-Notch-Filtern, die aus diskreten Dünnschichtwiderständen und Dünnschichtkondensatoren bestehen und auf einem gemeinsamen Substrat integriert sind.

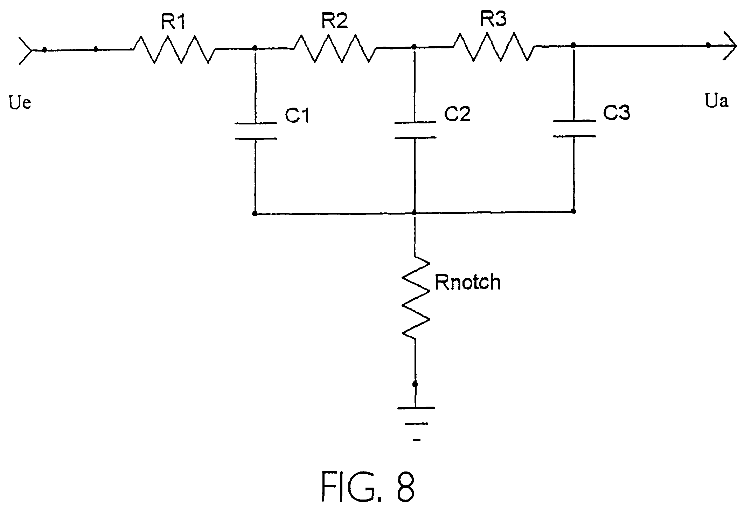

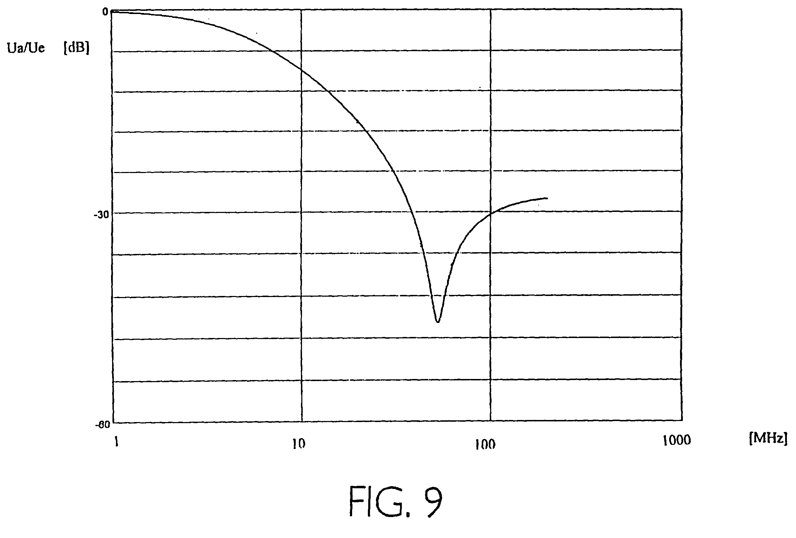

Jeder RC-Notch-Filter ist aus drei Kondensatoren und vier Widerständen, wie in Fig. 8 dargestellt, aufgebaut. Je nach gewünschter Filterkurve können auch mehr oder weniger Kondensatoren und Widerständen eingesetzt werden als in diesem Ausführungsbeispiel. Das prinzipielle Übertragungsverhalten von Eingangsspannung zu Ausgangsspannung (Ua/Ue) eines solchen Dünnschichtbauteils mit zwei RC-Filtern mit R1 von 300 Ω, R2 von 402 Ω, R3 von 249 Ω, R_{notch} von 13 Ω, C1 von 39 pF, C2 von 39 pF und C3 von 3 pF ist in Fig. 9 in Abhängigkeit von der Frequenz dargestellt. Der Eingang wurde mit 50 Ω, der Ausgang mit 10 kΩ abgeschlossen.

## Patentansprüche

1. Zero-IF-Konverter mit einem Dünnschichtbauteil mit mindestens zwei RC-Filtern mit jeweils einem Widerstand und einem Kondensator mit jeweils einer Unterelektrode, einer Oberelektrode und einem Dielektrikum,
dadurch gekennzeichnet,
daß die RC-Filter auf einem gemeinsamen Substrat angeordnet sind.

2. Zero-IF-Konverter gemäß Anspruch 1,
dadurch gekennzeichnet,
daß mindestens ein RC-Filter ein verteilter RC-Filter ist.

3. Zero-IF-Konverter gemäß Anspruch 1,
dadurch gekennzeichnet,
daß mindestens ein RC-Filter ein diskreter RC-Filter ist.

4. Zero-IF-Konverter gemäß Anspruch 2,
dadurch gekennzeichnet,
daß die Oberelektrode des verteilten RC-Filters widerstandsbehaftet ist.

5. Zero-IF-Konverter gemäß Anspruch 2,
dadurch gekennzeichnet,
daß die Unterelektrode des verteilten RC-Filters widerstandsbehaftet ist.

6. Zero-IF-Konverter gemäß Anspruch 1,
dadurch gekennzeichnet,
daß mindestens ein RC-Filter ein RC-Notch-Filter mit einem Notch-Widerstand ist.

7. Zero-IF-Konverter gemäß Anspruch 6,
dadurch gekennzeichnet,
daß der Notch-Widerstand ein diskretes Widerstandsbauelement ist.

8. Zero-IF-Konverter gemäß Anspruch 1,
dadurch gekennzeichnet,
daß das Substrat aus einem wärmeleitfähigen Material besteht.

9. Dünnschichtbauteil mit mindestens zwei RC-Filtern mit jeweils einem Widerstand und einem Kondensator mit jeweils einer Unterelektrode, einer Oberelektrode und einem Dielektrikum,
dadurch gekennzeichnet,
daß die RC-Filter auf einem gemeinsamen Substrat angeordnet sind.
